# EUROPÄISCHE PATENTSCHRIFT

(11) **EP 0 599 074 B1**
(45) Veröffentlichungstag und Bekanntmachung des Hinweises auf die Patenterteilung: **21.04.1999**
(21) Anmeldenummer: 93117463.5
(22) Anmeldetag: 28.10.1993
(51) Int. Cl.: H01L 21/768, H01L 21/3105

(54) **Verfahren zur globalen Planarisierung von Oberflächen integrierter Halbleiterchaltungen**
Method for the global planarization of surfaces of integrated semiconductor circuits
Procédé de planarisation globale des surfaces de circuits intégrés semi-conducteurs

(30) Priorität: 20.11.1992 DE 4239075
(43) Veröffentlichungstag der Anmeldung: 01.06.1994
(73) Patentinhaber: Micronas Intermetall GmbH, 79108 Freiburg (DE)
(72) Erfinder: Zimmer, Hans-Günter, Dr., D-79211 Denzlingen (DE)

(56) Entgegenhaltungen:
- EP-A- 0 084 635
- EP-A- 0 312 154
- EP-A- 0 405 850
- US-A- 4 634 496
- CHEMICAL PATENTS INDEX, DOCUMENTATION ABSTRACTS JOURNAL Section EI, Week 9009, Derwent Publications Ltd., London, GB; Class U, AN 90-063004 & JP-A-2 015 624 (MOTOROLA INC,) 19. Januar 1990

## Beschreibung

Die Erfindung betrifft ein Verfahren nach dem Oberbegriff des Anspruchs 1.

Ein solches Verfahren ist aus der US-A-634 496 und der EP 0 312 154 bekannt.

Aus der EP 0 416 165 ist ein Verfahren bekannt, bei dem zunächst eine aus Siliziumdioxid bestehende lokal planarisierte Isolationsschicht bestimmter Dicke auf der einzuebnenden strukturierten Schicht aufgebracht wird. Daraufhin werden als Hilfsebene invers zur darunterliegenden strukturierten Ebene Photolackstrukturen erzeugt. Eine weitere guthaftende und einzuebnende Hilfsschicht wird aufgebracht und der ganze Aufbau einer anisotropen Ätzung unterworfen. Dabei werden praktisch alle Hilfsschichten und die einzuebnende Schicht geätzt. Etwaige nach dem Rückätzen verbleibende Reste der Photolackstruktur werden abgelöst.

Bei der gegenwärtigen Tendenz zur Verkleinerung der Strukturen und der damit verbundenen Forderung nach Erhöhung des optischen Auflösungsvermögens der Belichtungsmaschinen können topographische Höhenschwankungen auf den Halbleiterschaltungen immer weniger hingenommen werden, weil mit zunehmender numerischer Apertur der Beschichtungsmaschinen deren Tiefenschärfe nicht mehr ausreicht, d.h. es zu einem Verlust an Tiefenschärfe kommt. Dadurch können beim Photoprozeß unerwünschte Photolackreste zurückbleiben. Mit der Zahl der Verdrahtungsebenen addieren sich zwangsläufig auch derartige Probleme. Große Schichtdicken machen sich ebenfalls nachteilig bemerkbar, außerdem kann man wiederum bei mehreren Verdrahtungsebenen dieselben nicht beliebig verkleinern.

Man kennt sogenannte lokale Planarisierungen, das sind Prozesse, bei denen z.B. eine Glasschicht in einem Temperschritt zum Fließen gebracht wird oder Prozesse, bei denen die Glasschicht zunächst abgeschieden und anschließend anisotrop rückgeätzt wird.

Daneben gibt es auch noch andere globale Planarisierungsmethoden, z.B. mechanisches Schleifen von Oxydschichten. Nachteilig ist dabei, daß man nicht nur eine zusätzliche Schleifeinrichtung benötigt, sondern auch, daß dabei Steppermarken eingeebnet werden. Eine Alternative hierzu bildet das eingangs genannte Verfahren.

Aufgabe der Erfindung ist es, die Nachteile der geschilderten Prozesse zu vermeiden und eine vereinfachte Schrittfolge gegenüber dem Bekannten zur globalen Planarisierung unter Verwendung von herkömmlichen, fertigungstechnisch bewährten Verfahren und Vorrichtungen anzugeben.

Die Aufgabe wird durch die in Anspruch 1 angegebene Erfindung gelöst, zweckmäßige Ausgestaltungen sind in den Unteransprüchen gekennzeichent.

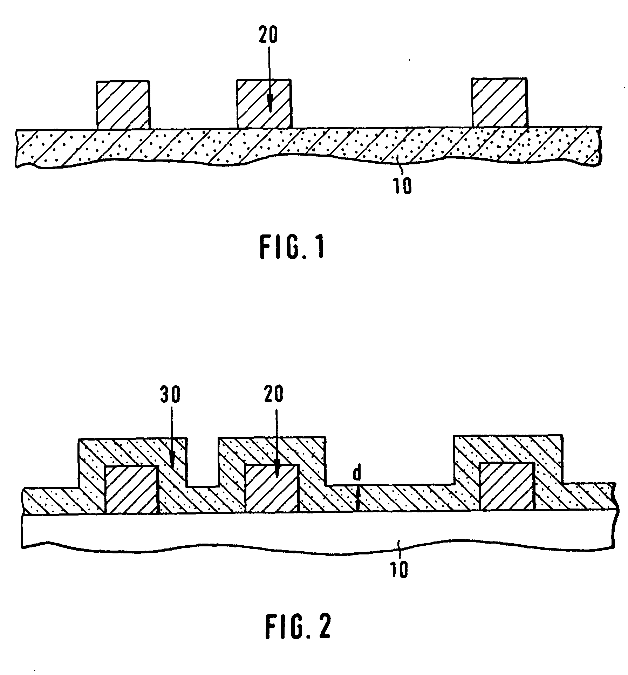

Anhand der Figuren 1 bis 4, die rein schematisch Schritte durch aufeinanderfolgende Herstellungsstufen von Halbleiterschaltungen darstellen, soll die Erfindung erläutert werden. Gleiche Merkmale sind in den Figuren mit gleichen Bezugszeichen versehen.

Ausgehend von einem Halbleiterkörper 10 mit darin enthaltenen, nicht eingezeichneten und nach herkömmlichen Verfahren hergestellten Strukturen eines Halbleiterbauelements werden auf der Oberfläche des. Halbleiterkörpers 10 an den erforderlichen Stellen Leiterbahnen 20 aus Metall, wie z.B. Aluminium, oder dotiertem Polysilizium aufgebracht (Fig. 1).

Die Oberfläche wird anschließend mit einer Dielektrikumsschicht 30 der Schichtdicke d aus z.B. SiO2 oder Phosphorsilikatglas überzogen. Die Abscheidung erfolgt dabei z.B. durch CVD (Fig. 2).

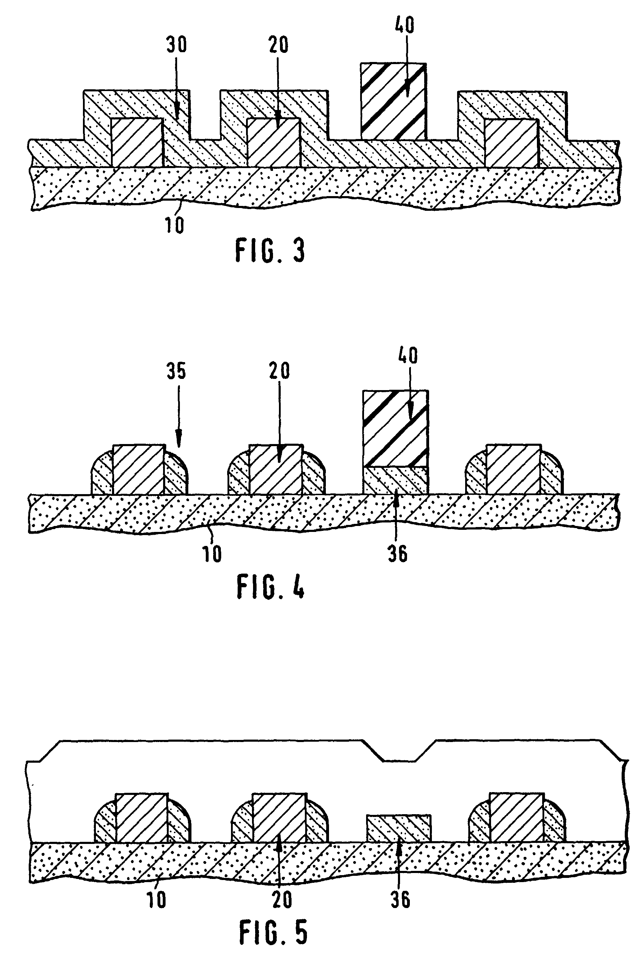

Als nächster Schritt wird nun eine Photolackschicht flächendeckend aufgebracht und unter Ausbildung der Photomaske 40 nach herkömlicher Weise strukturiert, und zwar dergestalt, daß sie die Schicht 30 im Bereich zwischen den Leiterbahnen 20 teilweise bedeckt. Der Minimalabstand der Photomaske 40 zu den Leitbahnen 20 ist durch technologisch vorgegebene Parameter wie Schichtdicken, Justiergenauigkeit der Belichtungsapparaturen, optische Eigenschaften der zu planarisierenden Bahnen, Auflösungsvermögen der Belichtungsmaschine für die Photomaske 40 usw. begrenzt. In praxi ist es jedoch weder notwendig noch wünschenswert, mit Minimalabständen zu arbeiten. Dort, wo die Abstände zwischen Leiterbahnen 20 zu klein sind, gibt es keine Photomaske 40 (Fig. 3). Dies sind Bereiche, in denen der Abstand zwischen den Leiterbahnen 20 größer ist als das Mehrfache der Dicke der Dielektrikumsschicht 30, und zwar unter Einbeziehung der Justiertoleranzen und der Phototechnik.

Nun wird durch anisotrope Ätzung die Schicht 30 abgetragen (Fig. 4). Es verbleiben am Rande der Leiterbahnen 20 Spacer 35, die eine lokale Planarisierung der Leiterbahnebene darstellen bzw. ggf. unterschnittene Flanken der Leiterbahnen 20 korrigieren. Außerdem verbleiben die unter der Photomaske verborgenen Dielektrikumsstücke 36. Anschließend wird die Photomaske 40 abgetragen und die Planarisierung in konventioneller Weise fortgesetzt, so daß man die in Fig. 5 gezeigte Struktur erhält.

Zur Unterstützung der angestrebten globalen Planarisierung kann vor der Abscheidung der Dielektrikumsschicht 30 eine dünne Dielektrikumsschicht 31 zur Vorplanarisierung aufgebracht werden aus z.B. Phosphorsilikatglas mittels SOG-Verfahren (nicht gezeigt).

Nachteilig bei dem erfindungsgemäßen Verfahren ist, daß ein zusätzlicher Maskenprozeß eingeführt werden muß. Dem steht gegenüber, daß mit diesem Verfahren u.U. ein zuverlässiger Herstellungsprozeß erst führbar ist. Dies gilt insbesondere bei Schaltungen mit nicht periodischen Leiterbahnstrukturen. Außerdem ist dieser Maskenprozeß unkritisch, wenn die zusätzlichen Dielektrikumsstücke hinreichend weit von den einzuebnenden Strukturen zu liegen kommen.
Die durch das Verfahren entstehenden Spacer an den Leiterbahnen tragen zur lokalen Planarisierung der Topographie bei. Sie sind an sich schon Bestandteil üblicherweise eingesetzter Planarisierungen.

Weiterhin entsteht kein zusätzlicher Aufwand im Schaltungsentwurf, weil sich die Zusatzmaske aus dem entsprechenden Verdrahtungslayout mit einem entsprechenden Rechnerprogramm ableiten läßt.

## Patentansprüche

1. Verfahren zur globalen Planarisierung von Oberflächen integrierter Halbleiterschaltungen, bei dem eine aus einem Dielektrikum bestehende Hilfsschicht zurückgeätzt wird, bestehend aus folgenden Schritten:
a) Herstellen der Verdrahtungsstruktur aus Leiterbahnen (20) nach einem der herkömmlichen Verfahren auf der Oberfläche eines Trägerkörpers (10) mit den darin ausgebildeten Bauelementen,
b) Abscheiden einer die gesamte Oberfläche abdeckenden Dielektrikumsschicht (30) der Schichtdicke d,
c) Aufbringen einer Photolackschicht über der Dielektrikumsschicht (30), gekennzeichnet durch,
d) Strukturierung der Photolackschicht mittels Phototechnik unter Ausbildung einer Photolackmaske (40), so daß sie die Dielektrikumsschicht (30) in den Bereichen zwischen Leiterbahnen (20) mit einem Abstand, der das mehrfache der Dicke d der Dielektrikumsschicht (30) beträgt, zur Ausbildung von Dielektrikumsstücken teilweise bedeckt, unter Berücksichtigung der Justiertoleranz und des optischen Auflösungsvermögens,
e) Anisotrope Ätzung der Dielektrikumsschicht (30) unter Freilegung der Leiterbahnen (20) und der Oberfläche des Trägerkörpers (10), wobei auf den Seiten der Leiterbahnen (20) Spacer (35) und die Dielektrikumsstücke unter der Photomaske (40) entstehen,
f) Ablacken und Fortsetzen des Planarisierungsvorgangs nach einem der herkömmlichen Verfahren.

2. Verfahren nach Anspruch 1, dadurch gekennzeichnet, daß zwischen den Schritten a) und b) die Abscheidung einer dünnen dielektrischen Schicht (31) zum Zwecke einer Vorplanarisierung vorgenommen wird.

3. Verfahren nach Anspruch 1 oder 2, dadurch gekennzeichnet, daß die Dielektrikumsschichten (30, 31) aus Siliziumdioxid gebildet sind.

4. Verfahren nach Anspruch 1 oder 2, dadurch gekennzeichnet, daß die Dielektrikumsschichten (30, 31) aus Silikatglas gebildet sind.

## Claims

1. A method for the global planarization of surfaces of semiconductor integrated circuits wherein an auxiliary layer made of a dielectric is etched back, comprising the steps of:
a) forming the interconnection pattern of conductive tracks (20) by one of the conventional processes on the surface of a substrate (10) with the components incorporated therein;
b) depositing a dielectric layer (30) of thickness d over the entire surface of the substrate (10);
c) depositing a photoresist layer over the dielectric layer (30),
characterized by
d) patterning the photoresist layer to form a photoresist mask (40) using photoresist technology, such that for the formation of dielectric portions, the photoresist mask (40) partly covers the dielectric layer (30) in those areas between the conductive tracks (20) where the spacing of the conductive tracks (20) is a multiple of the thickness d of the dielectric layer (30), taking into account the alignment tolerance and the optical resolution;
e) etching the dielectric layer (30) anisotropically to expose the conductive tracks (20) and the surface of the substrate (10), forming spacers (35) at the sides of the conductive tracks (20) and the dielectric portions below the photoresist mask (40); and
f) stripping the photoresist and continuing the planarization by a conventional process.

2. A method as claimed in claim 1, characterized in that between steps a) and b), a thin dielectric layer (31) is deposited for the purpose of preplanarization.

3. A method as claimed in claim 1 or 2, characterized in that the dielectric layers (30, 31) are made of silicon dioxide.

4. A method as claimed in claim 1 or 2, characterized in that the dielectric layers (30, 31) are made of silicate glass.

## Revendications

1. Procédé pour la planarisation globale de surfaces de circuits intégrés, dans lequel on effectue une gravure en retrait sur une couche auxiliaire constituée par du diélectrique, constitué par les étapes suivantes :
a) fabrication, selon un des procédés usuels, d'une structure de câblage constituée de bandes conductrices (20) sur la surface d'un corps support (10) comportant les composants qui y ont été formés,
b) dépôt d'une couche diélectrique (30) d'épaisseur d qui recouvre toute la surface,
c) dépôt d'une couche de laque photosensible sur la couche diélectrique (30), caractérisé par
d) la réalisation d'une structure de la couche de laque photosensible par technique photochimique en formant un masque en laque photosensible (40) de telle sorte qu'il recouvre partiellement la couche diélectrique (30) dans les zones entre des bandes conductrices (20) avec une distance qui est un multiple de l'épaisseur d en vue de former des morceaux de diélectrique en prenant en compte les tolérances d'ajustage et le pouvoir de résolution optique,
e) l'attaque anisotrope de la couche diélectrique (30) en libérant les bandes conductrices (20) et la surface du corps semi-conducteur (10), en créant des entretoises (35) sur les côtés des bandes conductrices (20) et des morceaux de diélectrique sous le masque de photogravure (40),
f) suppression de la laque et poursuite du processus de planarisation selon l'un des procédés connus.

2. Procédé selon la revendication 1, caractérisé en ce que, entre les étapes a) et b), on réalisel le dépôt d'une couche mince (31) en vue d'une planarisation préliminaire.

3. Procédé selon la revendication 1 ou 2, caractérisé en ce que les couches de diélectriques (30, 31) sont formées en dioxyde de silicium.

4. Procédé selon la revendication 1 ou 2, caractérisé en ce que les couches diélectriques (30, 31) sont formées en verre au silicate.
